# EUROPEAN PATENT APPLICATION

(11) **EP 4 746 617 A1**
(43) Date of publication of application: **20.05.2026**
(21) Application number: 25214555.2
(22) Date of filing: 10.11.2025
(51) Int. Cl.: H10B 12/00, G11C 8/14, G11C 5/06

(54) **MONOLITHIC FORMATION OF ARRAY AND PAD WORDLINES IN MEMORY CIRCUITS**

(30) Priority: 13.11.2024 US 202463720163 P; 19.09.2025 US 202519334796
(71) Applicant: Samsung Electronics Co., Ltd., Suwon-si, Gyeonggi-do 16677 (KR)
(72) Inventor: JEONG, Young Doo, San Jose, CA, 95134 (US); KIM, Dongwan, San Jose, CA, 95134 (US)
(74) Representative: Kuhnen & Wacker Patent- und Rechtsanwaltsbüro PartG mbB

(57) **Abstract**

A system and a method for a monolithic wordline, WL, are disclosed. A structure includes a conductive element and a first dielectric. The conductive element connects an array WL in an array area at a first edge to a pad WL in a pad area at a second edge. The conductive element is disposed in an interconnecting area between the first edge and the second edge. The first dielectric is disposed on the array WL, the conductive element, and the pad WL. The first dielectric has a dielectric surface extending from the interconnecting area to the pad area. The conductive element and the first dielectric form a monolithic WL from the array WL and the pad WL through the second edge.

## Description

### TECHNICAL FIELD

The disclosure generally relates to memory devices. More particularly, the subject matter disclosed herein relates to formation of array and pad wordlines in memory circuits.

### BACKGROUND

The present background section is intended to provide context only, and the disclosure of any concept in this section does not constitute an admission that said concept is prior art.

Three-dimensional (3D) memory configurations have been increasingly popular. 3D memory devices, such as vertically stacked dynamic random-access memory (VSDRAM) and vertical NAND (V-NAND) flash memory, include memory cells that are stacked vertically to increase storage density. One feature of 3D memory circuits is the arrangement of the bit lines (BLs) and wordlines (WLs). As the memory density increases, the arrangement of BLs and WLs may cause issues such as shorts which refer to the defective electrical connections between two points.

Existing techniques for preventing shorts and other device failures, however, face several challenges, especially for high density and high aspect ratio memory circuits. Techniques such as stitching WLs, precise device profile fabrication, optimized patterning and lithography, precise deposition of insulating materials, and analysis of device profiles are costly, difficult to implement, and may still have risks of shorts and defects.

The above information disclosed in this Background section is only for enhancement of understanding of the background of the disclosure and therefore it may contain information that does not constitute prior art.

### SUMMARY

To overcome these issues, systems and methods are described herein for a technique of forming an integrated array and pad wordline (WL) in a three-dimensional (3D) memory device. In some embodiments, a 3D memory device includes a structure that connects WLs from the WL pad area to the array area. The structure includes a conductive element and a first dielectric. The conductive element connects an array WL in the WL array area at a first edge to a pad WL in the WL pad area at a second edge. The conductive element is disposed in an interconnecting area between the first edge and the second edge. The first dielectric is disposed on the array WL, the conductive element, and the pad WL. The first dielectric has a dielectric surface extending from the interconnecting area to the WL pad area. The conductive element and the first dielectric form a monolithic WL from the array WL and the pad WL through the second edge.

In some embodiments, the structure further includes a second dielectric disposed on the first dielectric in the interconnecting area and a third dielectric disposed on the first dielectric in the WL pad area. In some embodiments, the predetermined thickness is equal to a gate oxide thickness. In some embodiments, the first dielectric is different from the second dielectric, the third dielectric, or both the second electric and the third electric.

### BRIEF DESCRIPTION OF THE DRAWINGS

In the following section, the aspects of the subject matter disclosed herein will be described with reference to exemplary embodiments illustrated in the figures, in which:
FIG. 1 is a block diagram illustrating a system that utilizes a 3D memory circuit according to an embodiment.
FIG. 2 is a diagram illustrating a 3D memory circuit that utilizes a monolithic WL structure according to an embodiment.
FIG. 3 is a diagram illustrating three views of a capping process flow of fabrication of the monolithic WL according to an embodiment.
FIG. 4 is a diagram illustrating a first half of the capping process flow of fabrication of the monolithic WL in a 3D view according to an embodiment.
FIG. 5 is a diagram illustrating a second half of the capping process flow of fabrication of the monolithic WL in a 3D view according to an embodiment.
FIG. 6 is a diagram illustrating a first half of the capping process flow of fabrication of the monolithic WL in an array view according to an embodiment.
FIG. 7 is a diagram illustrating a second half of the capping process flow of fabrication of the monolithic WL in an array view according to an embodiment.
FIG. 8 is a diagram illustrating a first half of the capping process flow of fabrication of the monolithic WL in an array view according to an embodiment.
FIG. 9 is a diagram illustrating a second half of the capping process flow of fabrication of the monolithic WL in an array view according to an embodiment.
FIG. 10 is a diagram illustrating a process flow of forming the interconnecting area according to an embodiment.
FIG. 11 is a diagram illustrating three views of a masking process flow of fabrication of the monolithic WL according to an embodiment.
FIG. 12 is a diagram illustrating a first half of the masking process flow of fabrication of the monolithic WL in an array view according to an embodiment.
FIG. 13 is a diagram illustrating a second half of the masking process flow of fabrication of the monolithic WL in an array view according to an embodiment.
FIG. 14 is a diagram illustrating a first half of the masking process flow of fabrication of the monolithic WL in an array view according to an embodiment.
FIG. 15 is a diagram illustrating a second half of the masking process flow of fabrication of the monolithic WL in an array view according to an embodiment.
FIG. 16 is a diagram illustrating a first half of the masking process flow of fabrication of the monolithic WL in an interconnecting view according to an embodiment.
FIG. 17 is a diagram illustrating a first half of the masking process flow of fabrication of the monolithic WL in an interconnecting view according to an embodiment.
FIG. 18 is a flow chart illustrating a process of fabricating the monolithic WL structure for a memory circuit according to an embodiment.
FIG. 19 is a flow chart illustrating the process 1820 of preparing one or more monolithic WL pathways using capping according to an embodiment.
FIG. 20 is a flow chart illustrating the process 1820 of preparing one or more monolithic WL pathways using masking according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements. In the following, figures depicting various components, structures, interconnections, configurations, and steps of fabrication, are mainly for illustrative purposes. They are not intended to describe these elements accurately. A cross-sectional representation may be used to refer to a 3D block in a 3D structure. In some cases, relevant parts in a figure are shown clearly while other parts are shown with less sharpness or clarity to avoid confusion and improve contrast and clarity. These parts may be referenced in earlier figures and therefore do not need to be described again. These parts may also have little relationship with the part(s) being described. In addition, the shading of the parts in the figures may not have a consistent design and may be changed to maintain clarity and contrast in the figures. For example, part A may have a light shading in Fig. X but may be heavily shaded in Fig. Y. Moreover, as mentioned above, components in a figure may not be drawn with proper scales.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

The term "monolithic," as used herein, refers to "formed of a single element." The single, or one-body, element may include a uniformly distributed material. A "monolithic formation" is a formation of elements at the same time to create a monolithic, single, or one-body element. This contrasts with formation of an element by stitching two or more separate elements together, or integrating two or more separate elements together by joining them or connecting them together. Stitching two or more separate elements together may create uneven surfaces at the stitching site such that the surfaces become skew, crooked, or warped which may lead to tier-to-tier shorts, breaks, and other defects.

The term "pathway," as used here in, refers to the patterned channel or trench that is prepared to be filled with material according to the designated function. When it is filled with metal, it becomes a conducting line used as a WL or BL in a memory circuit or any other conducting lines that carry signals in a circuit. The term "pathway" is sometimes used to mean a channel, a hollow space, a trench, a pattern, a patterned line, or a line.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Many applications, especially applications in Artificial Intelligence (AI) and signal processing, require a vast storage capacity and high throughput computations. To satisfy these needs, highly dense memory circuits in 3D are developed. A typical 3D dynamic random-access memory (DRAM) device may stack multiple layers of memory cells vertically. Bitlines (BLs) and wordlines (WLs) may be arranged vertically to access cells in different layers. BLs and WLs are conductive elements that are used to select memory cells which may be arranged in a row-and-column array. A WL pad is a structure that allows connecting the WLs to other parts of the memory circuit and external circuits. A WL may therefore run from the pad area to the array area. When this WL is formed running from the pad aera to the array area in one process step, the resulting WL may be referred to as a monolithic WL.

In the following, systems and methods are described for a technique of providing a monolithic formation of WLs from array WLs and pad WLs. In some embodiments, a 3D memory device includes a structure that connects WLs from the WL pad area to the array area. The WL pad area has one or more WLs, referred for ease of references as pad WLs. Similarly, the WL array area has one or more WLs, referred to as array WLs. Typically, the array WLs are shorter than the pad WLs. The structure includes a conductive element and a first dielectric. The conductive element connects an array WL in the WL array area at a first edge to a pad WL in the WL pad area at a second edge. The conductive element is disposed in an interconnecting area between the first edge and the second edge. The first dielectric is disposed on the array WL, the conductive element, and the pad WL. The first dielectric has a dielectric surface extending from the interconnecting area to the WL pad area. The conductive element and the first dielectric form a monolithic WL from the array WL and the pad WL through the second edge. The structure further includes a second dielectric disposed on the first dielectric in the interconnecting area and a third dielectric disposed on the first dielectric in the WL pad area. In some embodiments, the predetermined thickness is equal to a gate oxide thickness. In some embodiments, the first dielectric is different from the second dielectric, the third dielectric, or both the second electric and the third electric. In some embodiments, all three dielectrics are different from each other. The first edge is the boundary between the array area and the interconnecting area. The second edge is the boundary between the interconnecting area and the pad area and is referred to as a unit block edge. A unit block edge is an edge of a well-defined block of semiconductor that is used as a unit for some physical characteristics or quality measurement such as flatness, purity, geometrical regularity. The conductive element is a metal. In some embodiments, the metal may be any one of the following: tungsten (W), titanium nitride (TiN), molybdenum (Mo), aluminum (Al), copper (Cu), Cobalt (Co). ruthenium (Ru), iridium (Ir), platinum (Pt), tantalum (Ta), or rhodium (Rh). It may also be a combination of two or more of the above materials.

The fabrication process for the monolithic formation of the WLs in the 3D memory circuits has the result of having a flat surface of the conducting element between the array WL and the pad WL to avoid risks of shorting or breaks in the WL regions. This is achieved by forming the WLs in the array area and the WLs in the pad area at the same time as one or more monolithic WLs. This is in contrast with techniques that forming the array WLs and the pad WLs separately or one after the other, and then stitching them together. Stitching the WLs from two separate areas or regions may lead to tier-to-tier shoring or line breaks. These techniques of forming the two types of WLs separately result in uneven or skewed surface at the boundary between the connecting area and the pad area.

The technique is efficient in the fabrication process. It is especially advantageous for high aspect ratio vertically stacked memory circuits. The inherently flat surface is achieved due to the metal deposition taking place for the entire WL including the array area and the pad area at the same time.

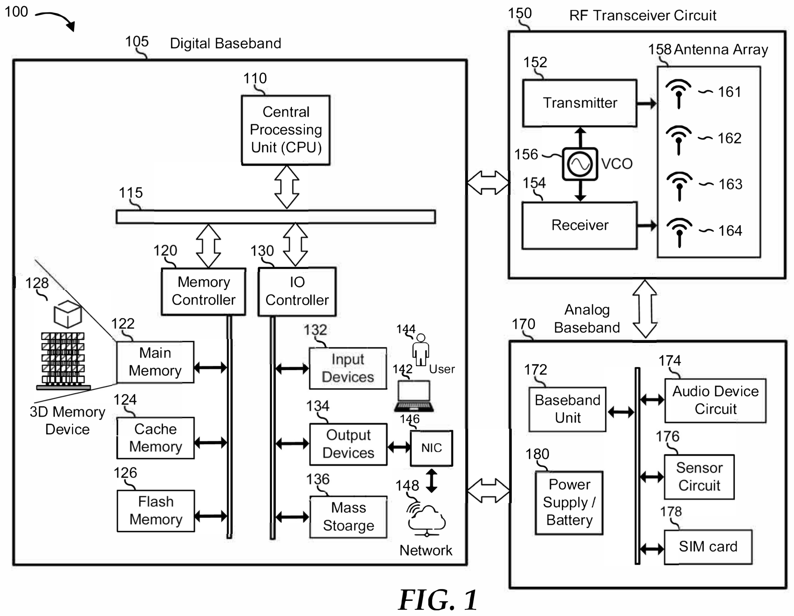

FIG. 1 is a block diagram illustrating a system that utilizes a 3D memory circuit according to an embodiment. The system 100 includes a digital baseband circuit 105, a radio frequency (RF) transceiver circuit 150, and an analog baseband circuit 170. The system 100 may represent a digital system or a mobile system. When the system 100 is used as a digital system without mobile circuitry, the RF transceiver circuit 160, and the analog baseband circuit 190 are not used. In addition, when the system 100 is used as a mobile device, many of the digital devices are scaled back and some devices may not be available.

The digital baseband circuit 105 includes central processing unit (CPU) 110, a memory controller 120, and an IO controller 130. The system 100 may include more or less than the above components. In addition, a component may be integrated into another component. The integration may be partial and/or overlapped. For example, the memory controller 120 and the I/O controller 130 may be integrated into one single controller.

The CPU 110 is a programmable device that may execute a program or a collection of instructions to carry out a task. It may be a host that controls or manages other processors or devices. In particular, the CPU 110 may include applications programming interfaces (APIs), applications, or drivers that are executed by the CPU 110 to perform specified tasks. The CPU 110 may be a general-purpose processor, a digital signal processor, a microcontroller, or a specially designed processor. It may include a single core or multiple cores. Each core may have multi-way multi-threading. The CPU 110 may have simultaneous multithreading feature to further exploit the parallelism due to multiple threads across the multiple cores. In addition, the CPU 110 may have internal caches at multiple levels. The CPU 110 communicates with other devices in the system via a bus 115. The bus 115 may be any suitable bus connecting the CPU 110 to other devices. For example, the bus 115 may be a Direct Media Interface (DMI). The bus 115 may also include other custom buses such as bus for the interface to the analog section when the system 100 is used as a mobile device.

The memory controller 120 controls memory devices such as a main memory 122, a cache memory 124, and a flash memory 126. The main memory 122 includes random access memory (RAM) including static RAM (SRAM) and dynamic RAM (DRAM) and/or the read-only memory (ROM) and other types of memory. The DRAM may include Synchronous DRAM (SDRAM), Double Data Rate SDRAM (DDR SDRAM) with variations (e.g., DDR2, DDR3, DDR4, DDR5, and DDR6). The main memory 122 may store instructions or programs, loaded from a mass storage device, that, when executed by the CPU 110, cause the CPU 110 to perform operations for a specified task. It may also store data used in the operations. The ROM may be a solid-state drive (SSD) and include instructions, programs, constants, or data that are maintained whether it is powered or not. The instructions or programs may correspond to the functionalities described in the following. In one embodiment, the main memory 122 includes a 3D memory device or circuit 128 such as VSDRAM and V-NAND flash memory, or any other memory devices that have memory cells that are stacked vertically to increase storage density

The I/O controller 130 controls input devices 132, output devices 134, and mass storage 136. The input devices 132 may include a keyboard, a mouse, an image sensor or camera, a game console, and a microphone. Other input devices may also be available such as stylus, joystick, scanner, and light pen. The input devices may also have a user interface to interface to a computer or laptop 142 and/or a user 144. The output devices 134 may include a printer, a monitor or screen, a headset, and a multi-monitor set. When used as a computing device without mobile features, the monitor is a high-resolution display. For games and other multi-display mode, the multi-monitor set provides high-resolution with multiple monitors (e.g., three monitors). When used for mobile communication, the screen provides the primary interface for the user to navigate, access various applications and perform tasks. The screen may use organic light-emitting diode (OLED) (super retina) display with multi-touch or haptic touch feature. The mass storage 136 may include CD-ROM, hard disk, and solid-state drives (SSDs). The I/O controller 130 also has a network interface card (NIC) 145 which provides an interface to a network and wireless medium 148.

Additional devices or bus interfaces may be available for interconnections and/or expansion. Some examples may include the Peripheral Component Interconnect Express (PCle) bus, the Universal Serial Bus (USB), etc.

The RF transceiver circuit 150 includes a transmitter 152, an antenna array 158, a voltage-controlled oscillator (VCO) 156, and a receiver 154. The RF circuit 150 operates at a high GHz frequency band to accommodate modern cellular equipment such as the wireless fifth generation (5G).

The transmitter 152 transmits the digital baseband data to the antenna array 158. The transmitter 152 may include a digital-to-analog converter (DAC), an automatic gain controller (AGC), an intermediate frequency (IF) circuit, a mixer, an RF circuit, and a power amplifier (PA). Other components may include filters, amplifiers, multiplexers, coaxial cables, phase shifters, etc. The DAC converts digital data f₁ into an analog signal f₂. The AGC automatically adjusts the signal amplitude of f₂ to generate a signal f₃ to maintain a consistent strength level in a dynamic and changing environment. The IF circuit performs intermediate frequency processes such as filtering to generate a signal f₄. The mixer converts the frequency of the signal f₄ to another frequency. This is done by mixing the signal f₄ with a signal vₜ from the VCO 156. Mixing here refers to frequency modulation which translates the signal f₄ to a signal f₅ at a different frequency. For transmitter, the translated frequency is higher than the frequency of f₄. The conversion is called up-conversion. For 5G communication, the frequency range may include low-band (below 1 GHz), mid-band (1 GHz to 6 GHz), and high-band (24 GHz to 53 GHz or higher). The resulting signal f₅ then goes through various radio frequency processes performed by the RF circuit such as highpass filtering to produce a signal f₆. The signal f₆ is strengthened and amplified by the PA to produce a signal f₇. The signal f₇ then goes to the antenna array 158 to be transmitted to an appropriate destination and medium (e.g., base station). The antenna array 158 uses beam forming to focus radio waves from f₇ in a desired direction. The antenna array 158 may be used for both transmitting and receiving. On receiving, the antenna array 158 receives an RF signal and sends it to the receiver 154. The number of antennas in the antenna array 158 depends on the desired coverage. The antenna array 158 may include antennas 161, 162, 163, and 164 configured to operate with 5G communication, Gigabit Long Term Evolution (LTE), Wi-Fi (e.g., 2.4 GHz, 5 GHz, and 6Ghz), and Bluetooth, respectively. The number of antennas may be more or less than the above.

The VCO 156 couples multiple in-phase oscillators together to provide low phase noise oscillation. It generates signals vₜ and vᵣ to the mixers at specified frequencies. It may include multiple oscillation core circuits (or VCO cores) to provide high-frequency periodic signals.

The receiver 154 processes the received signal r₇ in a manner reverse from the transmitter 152. It may include a low noise amplifier (LNA), an RF circuit, a mixer, an IF circuit, an AGC, and an analog-to-digital converter (ADC). The receiver 154 may include more or less than the above components. The LNA amplifies the weak signal r₇ while maintaining a good signal-to-noise ratio (SNR) to produce a signal r₆ for further processing. The signal r₆ is next processed by the RF circuit such as band-pass filtering to provide a signal r₅. Additional filtering may be performed in the next stages. The signal r₅ is then mixed with the signal vᵣ from the VCO 156 to down convert the signal r₅ to a signal r₄ at an appropriate low frequency. Like the mixer in the transmitter 152 but with a reverse operation, the mixer in the receiver performs frequency modulation to translate the high frequency signal r₅ to a low frequency signal r₄. The signal r₄ goes through IF processing such as additional filtering by the IF circuit to produce a signal r₃. The AGC amplifies and strengthens the signal and generates a signal r₂. The ADC converts the analog signal r₂ into digital data r₁ which will be processed by the CPU 110.

The analog baseband circuit 170 provides analog processing for various components. It handles processing of signals and data between the digital baseband circuit and the RF transceiver circuit 150. It may include analog and digital components to perform various tasks including modulation/demodulation, controlling the RF transceiver circuit 150, special circuitry for 3G, 4G/LTE, Bluetooth, and 5G communication. It may also interface with an audio device circuit 174, a sensor circuit 176, a Subscriber Identity Module (SIM) card 178, and other components. The audio device circuit 174 may include operational blocks to process audio signals and perform audio-related functions such as filtering, correlation, speech recognition. It may include digital circuits to perform Fast Fourier Transform (FFT) to perform signal processing in the frequency domain. The sensor circuit 176 may include a variety of sensors such as proximity, ambient light, motion (accelerometer and gyroscope, compass, barometer, fingerprint sensor for touch identification (ID), image sensors for face ID, light detection and ranging (LiDAR) scanner, etc. The SIM card 178 is a small, removable chip that stores the user's phone number and carrier information, allowing the device to connect to a cellular network.

The power supply and battery circuit 180 provides power and battery backup supply to the entire system. It may include a charger to charge the battery. The battery may be a rechargeable battery, of Lithium-Ion battery. Power management may be performed by application software and circuits to provide low power mode and performance management.

The system 100 is an example that illustrates the role of 3D memory devices in a laptop, desktop or mobile environment. In many cases, the environment of the applications adds additional requirements including low power consumption, reliable signal integrity, fault-tolerance, and reliable operations in extreme conditions including heat and tight space. Examples of other applications that would benefit from 3D memory devices or circuits include mobile communication (e.g., smart phones, base stations, user equipment), cameras, vehicles, entertainment (e.g., games, multimedia, music, movies), technical designs (e.g., animation, graphics), medical (e.g., visualization, medical imaging), robotics, drones, automatic test equipment, audio processing, speech synthesizer, video and image analysis, vision, automatic face recognition, artificial intelligence (AI) applications, and data centers.

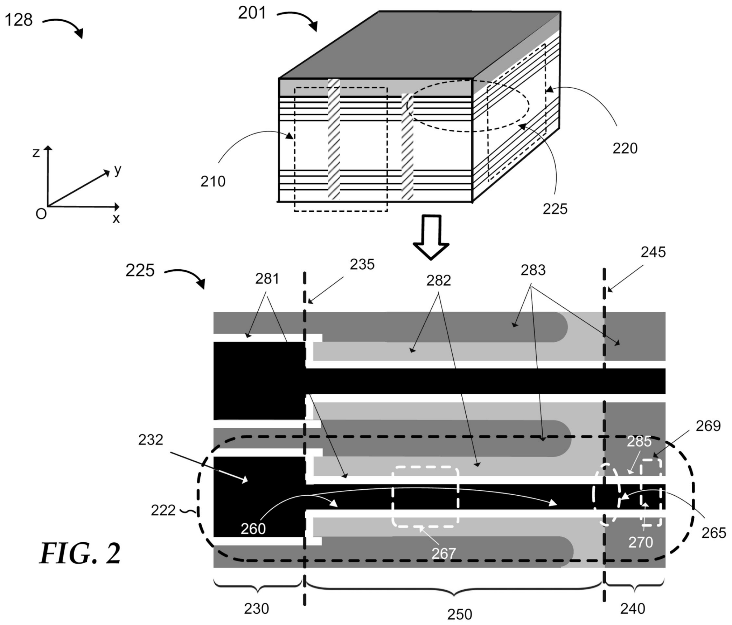

FIG. 2 is a diagram illustrating a 3D memory circuit 128 that utilizes a monolithic WL structure according to an embodiment. The 3D memory circuit 128 includes a structure 201 and other circuit elements (not shown). The structure 201 includes regions or areas 210, 220, and 225.

The area 210 is an area that has an array of memory cells that may be constructed by capacitors for storage elements and transistors for switching control to select, enable, or disable the storage elements during memory access operations. This array of memory cells may include one or more bit lines (BLs) and word lines (WLs) that provide conductive paths to the storage elements for memory addressing. For ease of reference, this area 210 may be referred to as an array area and a WL in the array area may be referred to as an array WL.

The area 220 is an area that has pads for connecting the WLs to other circuits such as row decoders. It may be referred to as WL pad area, or pad area. The WL pad area 220 includes one or more WLs that extend to the array area 210 to form one or more monolithic WLs. For ease of reference, this area 220 may be referred to as a WL pad area, or simply pad area, and a WL in the pad area may be referred to as a pad WL. In some embodiments, the array WL is shorter than the pad WL. A WL in a memory circuit is a single line and monolithic. The designations of array WL and pad WL does not refer to two different WLs. Rather, these terms refer to the same WL that reside in two different areas. The portion of the WL that resides in the array area 210 will be referred to as array WL and the portion of WL that resides in the WL pad area 220 will be referred to as pad WL. Similarly, when a WL runs through an interconnecting area that connects the array area and the pad area, the portion of that WL in the interconnecting area may be referred to as interconnecting WL. The designations of "array WL," interconnecting WL," and "pad WL" are mainly for ease of reference. For each WL, these three designations refer to a same single and monolithic WL extending from inside the pad area 220 to inside the array area 230 through the interconnecting area 250.

The region or area 225 is the area where one or more array WLs and one or more pad WLs are joined or connected to form one or more monolithic WLs. The cross section of the region 225 is shown to illustrate the arrangement of various elements. This cross section illustrates the internal structure of the 3D structure 210 where the array area and the pad area may be viewed as located on the same plane. The area 225 is segmented or divided into three segments or areas: an array area 230, a pad area 240, and an interconnecting area 250. The array area 230 and the interconnecting area 250 are separated by a boundary or edge 235, referred to as a first edge 235. The pad area 240 and the interconnecting area 250 are separated by a boundary or edge 245, referred to as a second edge 245. The second edge 245 may also be referred to as a unit block edge as explained above. The area 225 includes a structure 222 corresponding to a WL in the memory circuit.

The structure 222 includes an array WL 232 in the array area 230, a pad WL 270 in the pad area 240 and a conductive element 260 in the interconnecting area 250. The conductive element 260 is an interconnecting WL. As mentioned above, though they are referred to by three different names, the array WL, interconnecting WL, and pad WL are a single monolithic WL that is formed at the same time by the same material. The array WL 232, the interconnecting WL 260, and the pad WL 270 are made of, or include a metal. In one embodiment, the metal is at least one of tungsten (W), titanium nitride (TiN), molybdenum (Mo), aluminum (Al), copper (Cu), Cobalt (Co). ruthenium (Ru), iridium (Ir), platinum (Pt), tantalum (Ta), or rhodium (Rh). The metal may also be a combination of the above elements. The conductive element or interconnecting WL 260 connects the array WL 252 in the array area 230 at the first edge 235 to the pad WL 270 in the pad area 240 at the second edge 245. The conductive element or interconnecting WL 260 is disposed in the interconnecting area 250 between the first edge 235 and the second edge 245.

The structure 222 further includes a first dielectric 281, a second dielectric 282, and a third dielectric 283. The arrangements of these dielectrics are represented by an arrangement 267 in the interconnecting area and an arrangement 269 in the pad area. In some embodiments, at least one of the first dielectric 281, the second dielectric 282, and the third dielectric 283 includes silicon dioxide (SiO₂), silicon nitride (SiN), tantalum pentoxide (Ta₂O₅), titanium dioxide (TiO₂), or other high-k dielectrics. In one embodiment, each includes a different dielectric. In another embodiment, at least the first dielectric 281 includes a dielectric different than both the second dielectric 282, and a third dielectric 283.

The first dielectric 281 is disposed on the array WL 232, the conductive element 260, and the pad WL 270. The first dielectric 281 has a dielectric surface 285 extending from the interconnecting area 250 to the WL pad area 240. As discussed above, the conductive element 260 and the first dielectric 281 form a monolithic WL. In some embodiments, the dielectric surface 285 is flat having an unevenness less than a predetermined thickness at least in an area 265 around the second edge 245. The evenness is defined as the difference between the smallest thickness and the largest thickness of a surface, In some embodiment, the predetermined thickness is equal to one of a gate oxide thickness, between sub nm to 2 nm, or between 2 nm to 3 nm.

The second dielectric 282 is disposed on the first dielectric 281 in the interconnecting area 250, extending from the first edge 235 to the second edge 245 as shown in the arrangement 267. In some embodiments, the second dielectric 282 extends from one conductive element 260 to an adjacent conductive element 261 in the interconnecting area 250.

The third dielectric 283 is disposed on the first dielectric 281 in the pad area 240, stretching from one pad WL 270 to an adjacent pad WL 271 in the pad area 240 as shown in the arrangement 269. In some embodiments, the third dielectric 283 extends from the array area 230 between two adjacent first dielectrics to near the second edge 245 inside the second dielectric 282.

The dielectric surface 285 is achieved because the deposition of metal into the array WL 232, pad WL 270, and the interconnecting WL 260 occurs at the same time. The metal is allowed to fill up the conductive pathways reserved for the WL within the recessed channel and therefore acquires the flat surface at the periphery of the channel in the vertical direction. This is formed by a fabrication process.

There are two embodiments for the fabrication process. One is called a capping process and one is a masking process. Both processes differ in the way to mask the array and the pad sides.

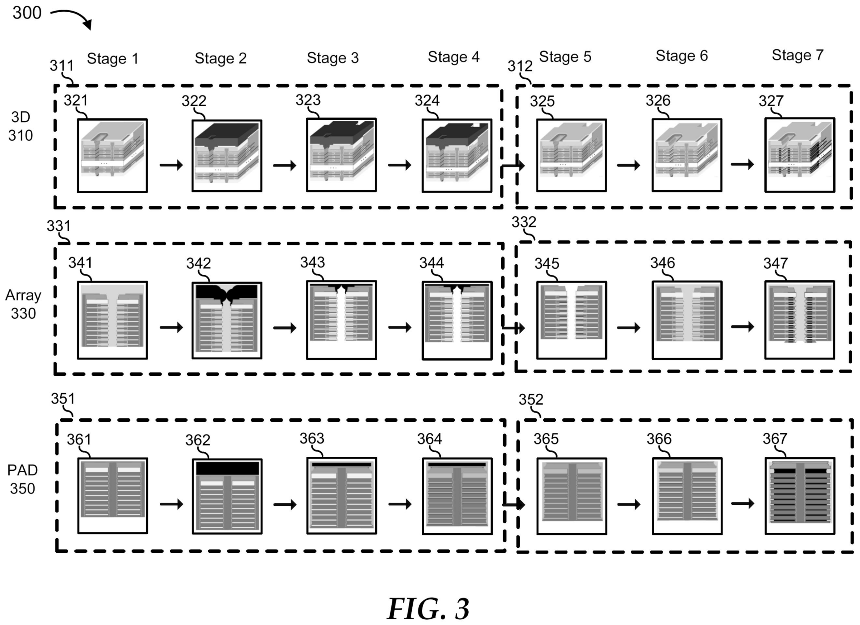

FIG. 3 is a diagram illustrating three views of a capping process flow 300 of fabrication of the monolithic WL according to an embodiment. The process 300 has three views: a 3D view 310, an array view 330, and a pad view 350. The process 300 includes 7 stages. Each stage can be seen in one of the above three views. To maintain clarity and efficiency in presenting the drawings, each view is divided into two parts. The first part includes stages 1 through 4 and the second part includes stages 5 through 7.

Stage 1 partially forms the array WLs on the 3D structure. Stage 2 deposits a capping mask on top of the 3D structure. Stage 3 etches and opens the WL pad area. Stage 4 strip the silicon paths. Stage 5 removes the capping mask. Stage 6 removes the liner oxide. Stage 7 deposits metal into the WL paths.

The 3D view 310 includes a first part 311 and a second part 312. The first part 311 includes structures 321, 322, 323, and 324 corresponding to stages 1, 2, 3, and 4, respectively. The second part 312 includes structures 325, 326, and 327 corresponding to stages 5, 6, and 7, respectively. Elements in the array view 330 and the pad view 350 may not be visible in the 3D view 310.

The array view 330 includes a first part 331 and a second part 332. The first part 331 includes structures 341, 342, 343, and 344 corresponding to stages 1, 2, 3, and 4, respectively. The second part 332 includes structures 345, 346, and 347 corresponding to stages 5, 6, and 7, respectively. Elements in the 3D view 310 and the pad view 350 may not be visible in the array view 330.

The pad view 350 includes a first part 351 and a second part 352. The first part 351 includes structures 361, 362, 363, and 364 corresponding to stages 1, 2, 3, and 4, respectively. The second part 352 includes structures 365, 366, and 367 corresponding to stages 5, 6, and 7, respectively. Elements in the 3D view 310 and the array view 330 may not be visible in the pad view 350.

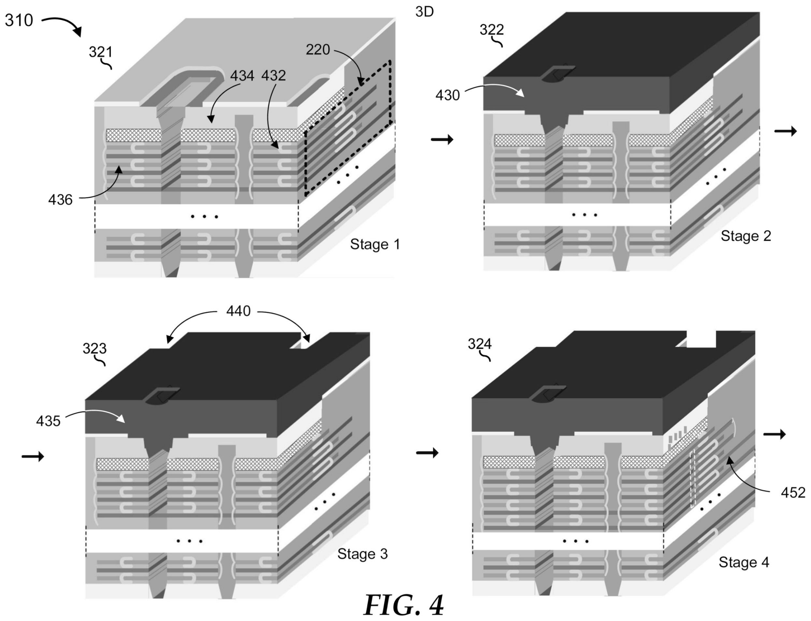

FIG. 4 is a diagram illustrating the first part 311 of the capping process flow of fabrication of the monolithic WL in a 3D view according to an embodiment. The first part 311 includes structures 321, 322, 323, and 324 corresponding to stages 1, 2, 3, and 4 shown in FIG. 3, respectively.

Stage 1 forms the structure 321 by partially creating patterns of the WL pathways 410 and 420. The patterns and pathways form the area 220 as shown in FIG. 2. The pathway 410 represents the array WL pathway and the pathway 420 represents the pad WL pathway. The cut-out shows the internal structure of the patterns. The structure includes dielectrics 432 and 434 and semiconductor (e.g., silicon Si, polysilicon, silicon germanium SiGe) 436. These patterns will be further etched and deposited with other materials in subsequent stages.

Stage 2 forms the structure 322 by depositing a cap 430 on top the of structure 321 in stage 1. The cap 430 may be a suitable material to allow selective etching with a hard mask. In some embodiments, the cap 430 includes amorphous carbon (abbreviated as aC or a-C). The objective is to mask the array side while opening another trench used for pad side. The cap 430 protects the underneath parts from contamination. The cap 430 may be deposited by any suitable deposition technique such as physical vapor deposition (PVD), atomic layer deposition (ALD), chemical vapor deposition (CVD), or Spin-on glass (SOG).

Stage 3 forms the structure 323 by etching and opening the WL pad area 440. The cap 430 serves as a hard mask for pad side opening. This is done by planarizing the cap 430 by a planarizing process such as CMP. The cap 430 is reduced in height to become a planarized cap 435.

Stage 4 forms the structure 324 by stripping the semiconductor (e.g., Si/Poly/SiGe) on pathways 452 in the pad area.

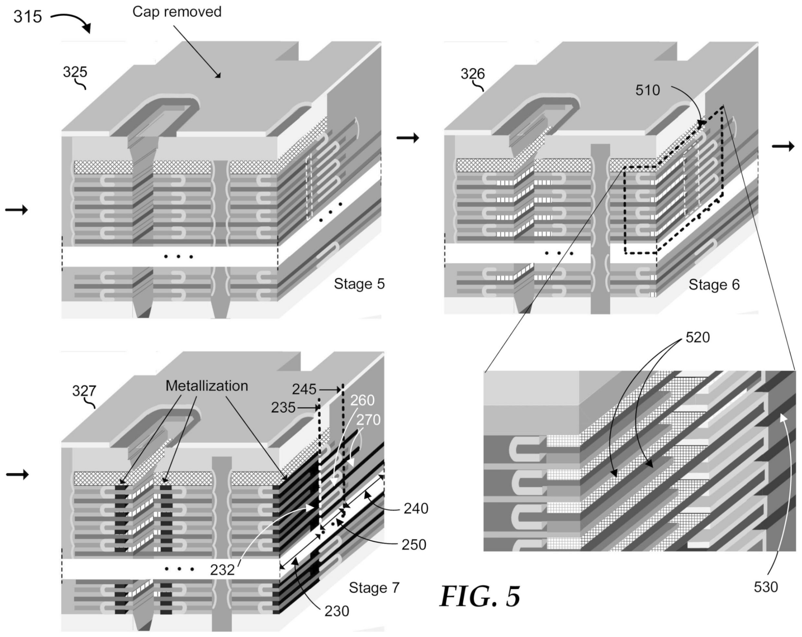

FIG. 5 is a diagram illustrating the second part 312 of the capping process flow of fabrication of the monolithic WL in a 3D view according to an embodiment. The second part 312 includes structures 325, 326, and 327 corresponding to stages 5, 6, and 7 shown in FIG. 3, respectively.

Stage 5 forms the structure 325 by removing the cap mask 430. In some embodiments, the removal may be done using oxygen plasma. This may be carried out by generating oxygen plasma which contains reactive species such as oxygen radicals. The oxygen radicals react with the capping material (e.g., aC) to generate volatile byproducts (e.g., carbon monoxide CO, carbon dioxide CO₂) which may be removed using vacuum pump.

Stage 6 forms the structure 326 by removing the liner dielectric (e.g., oxide). This creates hollow spaces at the silicon pathways in the array area and the pad area. These hollow spaces correspond to the WLs that extend from the array area (the array WLs) to the pad area (the pad WLs). A cleaning process to clean the dielectrics to connect the array hollow spaces to the pad hollow spaces. An expanded view 510 shows the internal structure of the array hollow spaces 520 and the pad hollow space 530. The expanded view 510 has a slightly different shading in some parts to improve the clarity. These hollow spaces will allow the metallization to be carried out in both the array and pad areas simultaneously, resulting in uniform and flat surface at the boundaries between the array area, the interconnecting area, and the pad area as shown in FIG. 2.

Stage 7 forms the structure 327 by metallization after depositing oxide material to the semiconductor (e.g., Si, poly, SeGe) in the array area while repairing any seam or void by the dielectric in the pad area. Metallization is done by depositing metal (e.g., TiN, W, Mo) in the array hollow spaces and pad hollow spaces to form uniform and monolithic WLs extending from the pad area to the array area. Since the metal is deposited in the array and pad areas at the same time through the hollows spaces that have been cleaned and prepared, the resulting WLs have a flat and even surface throughout. Because of this, shorts or defects on the WLs are eliminated. The array area 230, interconnecting area 250, and pad area 240 are as shown in FIG. 2. Similarly, the resulting WLs are 232, 260 and 270 as shown in FIG. 2. The first and second edges 235 and 245 are as shown in FIG. 2.

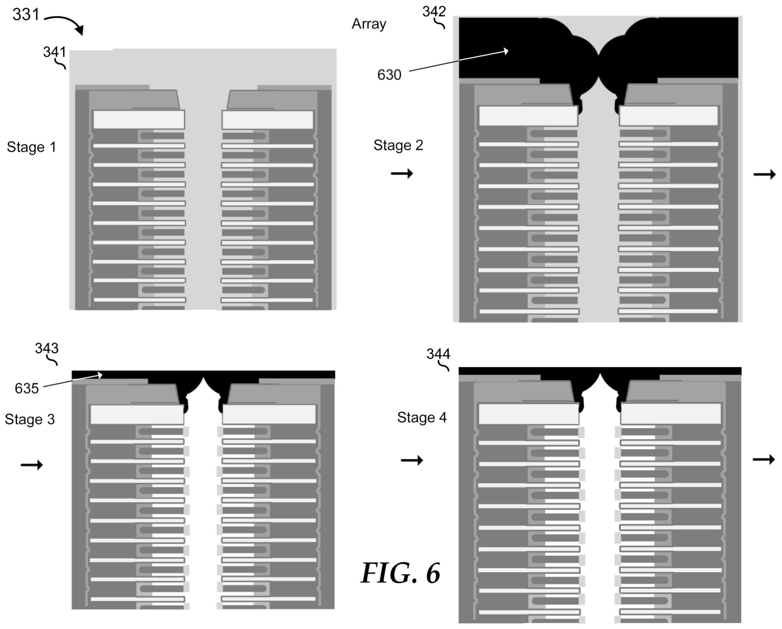

FIG. 6 is a diagram illustrating the first part 331 of the capping process flow of fabrication of the monolithic WL in an array view according to an embodiment. The first part 331 includes structures 341, 342, 343, and 344 corresponding to stages 1, 2, 3, and 4 shown in FIG. 3, respectively.

The structures 341, 342, 343, and 344 correspond to the stages 1, 2, 3, and 4, respectively, as shown in FIG.3. They are viewed from the array area in a 2-D view. The elements in the structures 341, 342, 343, and 344 are the same elements in the structures 321, 322, 323, and 324, respectively, shown in FIG. 4, except that they are viewed as 2D views in the array area. Accordingly, their descriptions are not repeated here except some observations. The cap 430 in FIG. 4 becomes a cap 630 as seen from the array view. The planarized cap 435 in FIG. 4 becomes a cap 635 as seen from the array view.

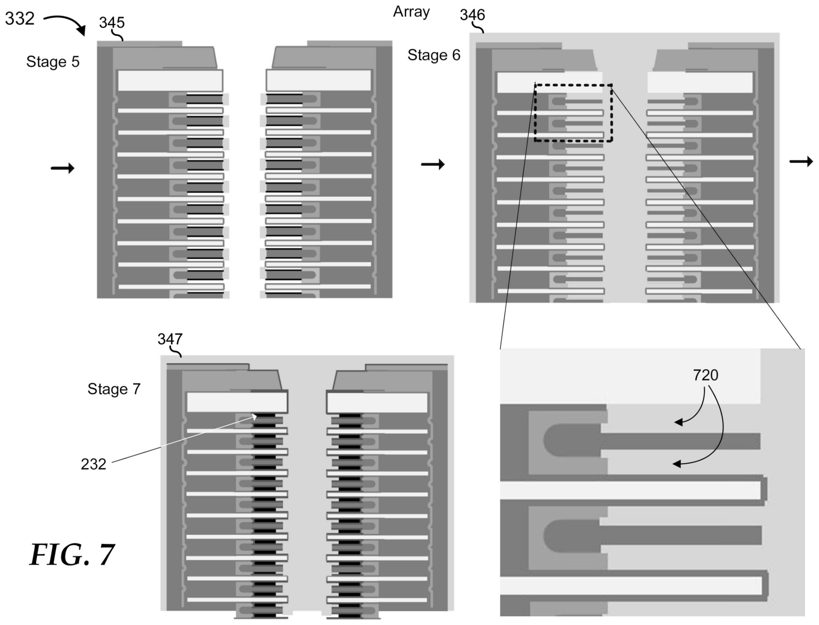

FIG. 7 is a diagram illustrating the second part 332 of the capping process flow of fabrication of the monolithic WL in an array view according to an embodiment. The second part 332 includes structures 345, 346, and 347 corresponding to stages 5, 6, and 7 shown in FIG. 3, respectively.

The structures 345, 346, and 347 correspond to the stages5, 6, and 7, respectively, as shown in FIG. 3. They are viewed from the array area in a 2-D view. The elements in the structures 345, 346, and 347 are the same elements in the structures 325, 326, and 327, respectively, shown in FIG. 5, except that they are viewed as 2D views in the array area. Accordingly, their descriptions are not repeated here except some observations. The hollow spaces 520 in FIG. 5 become hollow spaces 720 in the structure 346. The array WL 232 is shown in the structure 347. Since these figures are viewed as the array area, elements in the pad area are not visible.

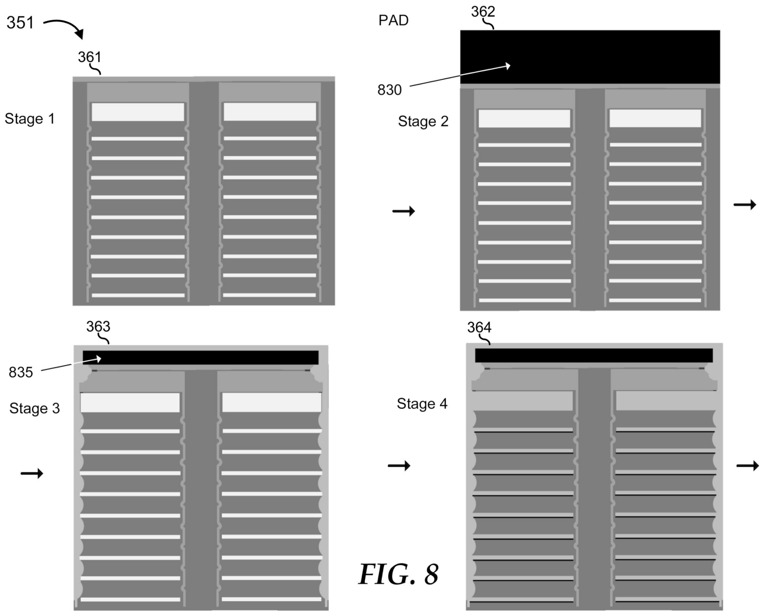

FIG. 8 is a diagram illustrating the first part 351 of the capping process flow of fabrication of the monolithic WL in a pad view according to an embodiment. The first part 351 includes structures 361, 362, 363, and 364 corresponding to stages 1, 2, 3, and 4 shown in FIG. 3, respectively.

The structures 361, 362, 363, and 364 correspond to the stages 1, 2, 3, and 4, respectively, as shown in FIG.3. They are viewed from the array area in a 2-D view. The elements in the structures 361, 362, 363, and 364 are the same elements in the structures 321, 322, 323, and 324, respectively, shown in FIG. 4, except that they are viewed as 2D views in the pad area. Accordingly, their descriptions are not repeated here except some observations. The cap 430 in FIG. 4 becomes a cap 830 as seen from the pad view. The planarized cap 435 in FIG. 4 becomes a cap 835 as seen from the pad view.

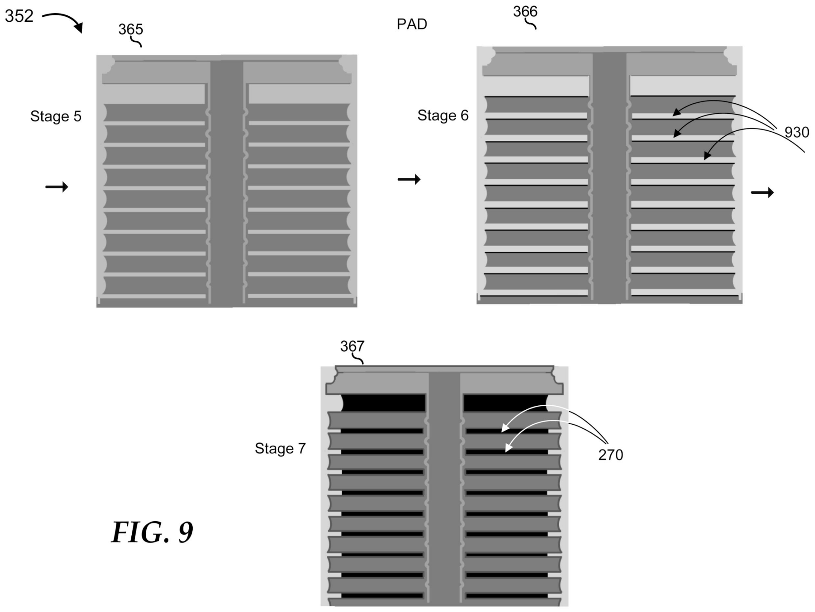

FIG. 9 is a diagram illustrating the second part 352 of the capping process flow of fabrication of the monolithic WL in a pad view according to an embodiment. The second part 352 includes structures 365, 366, and 367 corresponding to stages 5, 6, and 7 shown in FIG. 3, respectively.

The structures 365, 366, and 367 correspond to the stages 5, 6, and 7, respectively, as shown in FIG. 3. They are viewed from the pad area in a 2-D view. The elements in the structures 365, 366, and 367 are the same elements in the structures 325, 326, and 327, respectively, shown in FIG. 5, except that they are viewed as 2D views in the pad area. Accordingly, their descriptions are not repeated here except some observations. The pad hollow spaces 530 in FIG. 5 become hollow spaces 930 in the structure 366. The pad WL 270 is shown in the structure 367. Since these figures are viewed as the pad area, elements in the array area are not visible.

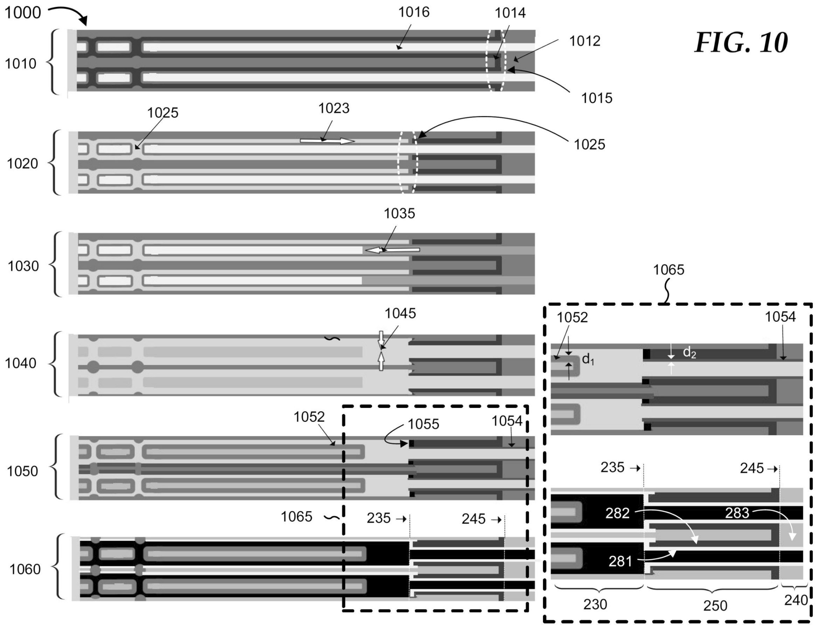

FIG. 10 is a diagram illustrating a process flow 1000 of forming the interconnecting area according to an embodiment. The process flow 1000 illustrates the formation of the interconnecting element that connects the array WL and the pad WL in a single metallization that occurs in both the array area and the pad area at the same time to form a uniform and monolithic WL. The process flow 1000 corresponds to the process flow 300 in FIG. 3 but with focus on the interconnecting area. It includes structures 1010, 1020, 1030, 1040, 1050, and 1060. Each structure is a result of a process stage operating on the previous structure. For the structure 1010, the previous structure is the 3D substrate. The sequence of the process stages is the same as the sequence in FIG. 3.

Stage 1 forms the structure 1010 with dielectrics 1012 and 1014 and semiconductor channel 1016. An edge 1015 is formed across the dielectrics 1012, 1014 and the semiconductor channel 1016. Stage 3 forms the structure 1020 with a silicon nitride (SiN) recess as shown with arrow 1023. The recess stops at an edge 1025. Stage 4 forms the structure 1030 by performing Si strip as shown by arrow 1035. Stage 6 forms the structure 1040 by oxide cleaning as shown by arrows 1045. The first part of stage 7 forms the structure 1050 by depositing gate oxide (Gox) at 1052, 1054, and 1055. In one embodiment, the oxide is of the low temperature chemical bath deposition (CBD) type for ease of cleaning. The thickness of the Gox layer 1052 in the array area around the silicon pathway is thicker than layer 1054 in the pad area to provide better chemical reaction with silicon. The second part of stage 7 forms the structure 1060 by depositing metal (e.g., TiN). The structure 1060 shows the array area 230, the interconnecting area 250, and the pad area 240. The first edge 235 corresponds to the edge 1025 at the structure 1020. The second edge 245 corresponds to the edge 1015 at the structure 1010. The dielectrics 281, 282, and 283 are formed from the dielectrics 1012 and 1014. Part of the structures 1050 and 1060 is shown in an expanded view 1065. The expanded view 1065 shows the thickness of the layer 1052 d₁ larger than the thickness d₂ of the layer 1054.

A second embodiment for a process to form the monolithic WL is referred to as a masking process. This process is similar to the capping process in FIG. 3 in the last two stages: stage 6 and stage 7 shown in FIG. 3.

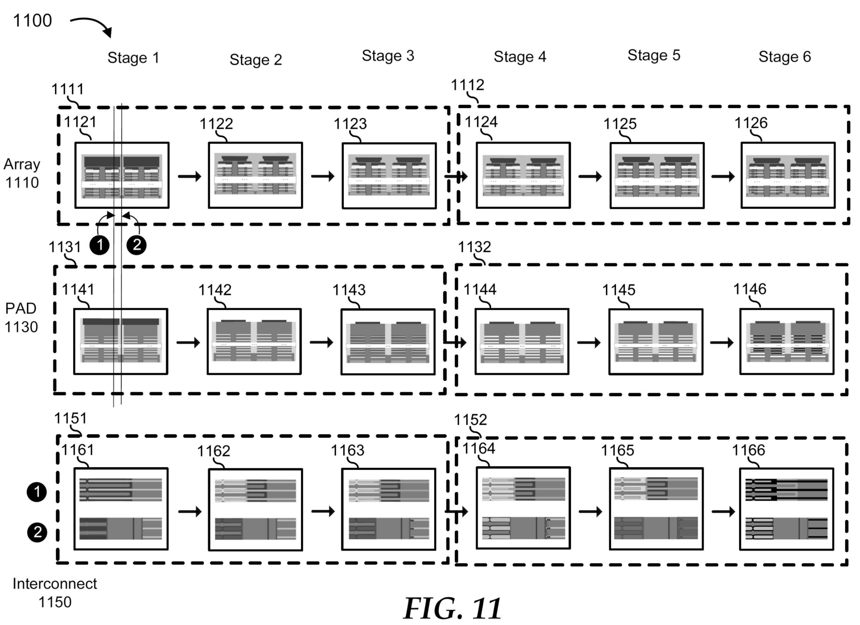

FIG. 11 is a diagram illustrating three views of a masking process flow 1100 of fabrication of the monolithic WL according to an embodiment. The process 1100 has three views: an array view 1110, a pad view 1130, and an interconnect view 1150. The process 1100 includes 6 stages. Each stage can be seen in one of the above three views. To maintain clarity and efficiency in presenting the drawings, each view is divided into two parts. The first part includes stages 1 through 3 and the second part includes stages 4 through 6.

Stage 1 etches the array and pad areas using oxide high aspect ratio (HAR) etching. Stage 2 forms channel silicon nitride liner recess. Stage 3 strips the semiconductor (e.g., silicon). Stage 4 cleans the liner oxide. Stage 5 deposits the gate oxide. Stage 6 deposits metal into the WL paths.

The array view 1110 includes a first part 1111 and a second part 1112. The first part 311 includes structures 1121, 1122, and 1123 corresponding to stages 1, 2, and 3, respectively. The second part 1112 includes structures 1124, 1125, and 1126 corresponding to stages 5, 6, and 7, respectively. Elements in the pad view 1130 and the interconnection view 1150 may not be visible in the array view 1110.

The pad view 1130 includes a first part 1131 and a second part 1132. The first part 1131 includes structures 1141, 1142, and 1143 corresponding to stages 1, 2, and 3, respectively. The second part 1132 includes structures 1144, 1145, and 1146 corresponding to stages 4, 5, and 6, respectively. Elements in the array view 11\10 and the interconnection view 1150 may not be visible in the pad view 1130.

The interconnect view 1150 includes a first part 1151 and a second part 1152. The first part 1151 includes structures 1161, 1162, and 1163 corresponding to stages 1, 2, and 3, respectively. The second part 1152 includes structures 1164, 1165, and 1166 corresponding to stages 4, 5, and 6, respectively. Elements in the array view 1110 and the pad view 1130 may not be visible in the array view 1110.

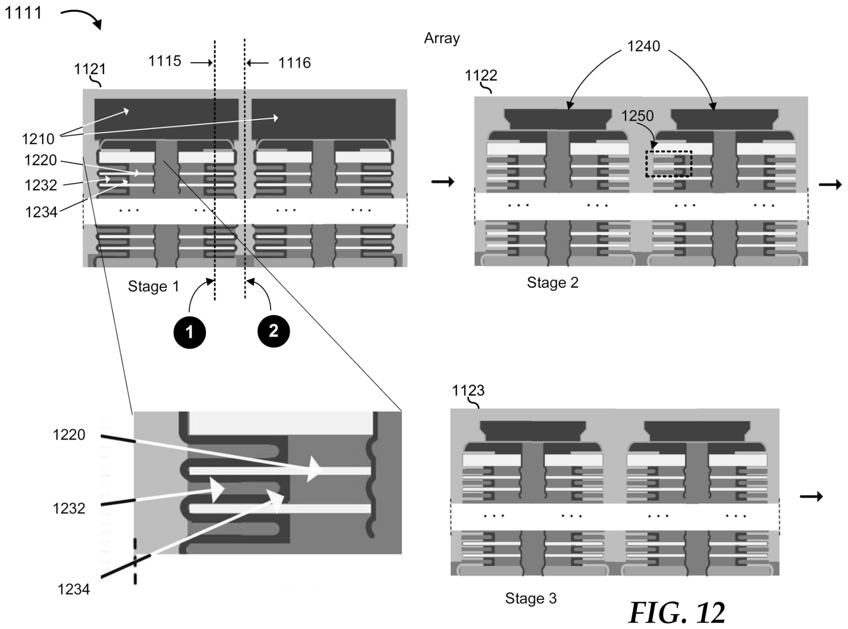

FIG. 12 is a diagram illustrating the first part 1111 of the masking process flow 1130 shown in FIG. 11 of fabrication of the monolithic WL in an array view according to an embodiment. The first part 1111 includes structures 1121, 1122, and 1123 corresponding to stages 1, 2, and 3 shown in FIG. 11, respectively.

Stage 1 forms the structure 1121 a hard mask 1210 on top of the 3D structure. The patterns include patterns for semiconductor (e.g., silicon) 1220 and dielectrics 1232 and 1234. Stage 2 forms the structure 1122 by opening the hard mask 1210 so that it becomes mask 1240. Oxide SiN liner recess 1250 is formed. Stage 3 forms the structure 1123 by stripping semiconductor (e.g., silicon).

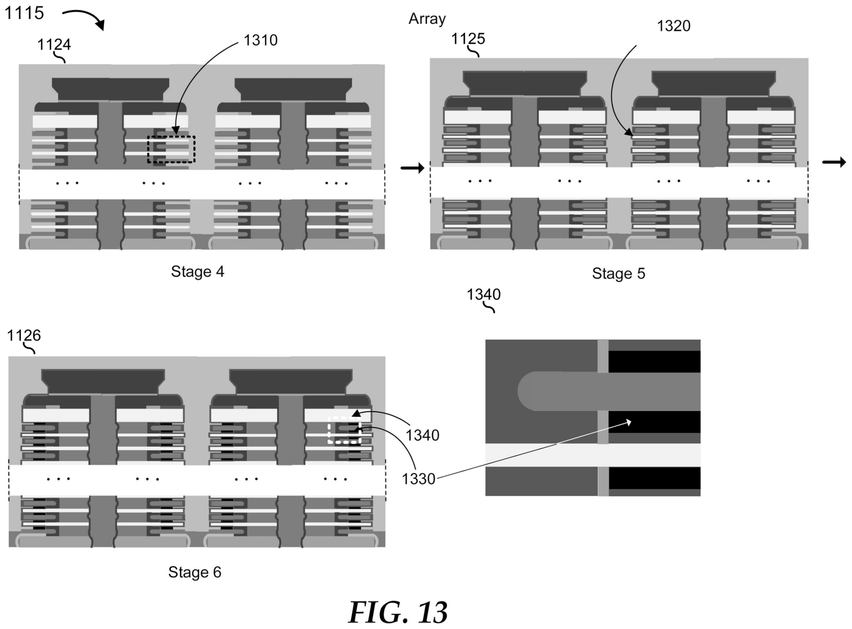

FIG. 13 is a diagram illustrating the second part 1112 of the masking process flow 1130 shown in FIG. 11 of fabrication of the monolithic WL in an array view according to an embodiment. The second part 1112 includes structures 1124, 1125, and 1126 corresponding to stages 4, 5, and 6 shown in FIG. 11, respectively.

Stage 4 forms the structure 1124 by cleaning the liner oxide, resulting cleaned semiconductor and dielectric channels 1310. Stage 5 forms the structure 1125 by depositing gate oxide 1320 at the semiconductor and dielectric channels. This stage is similar to the first part of stage 7 in the capping process shown in FIG. 3. Stage 6 forms the structure 1126 by depositing metal (e.g., Ti, W) into the hollow spaces in the array area and pad area to form w WL 1330. An expanded view 1340 shows the WL 1330. This stage is similar to the second part of stage 7 in the capping process shown in FIG. 3.

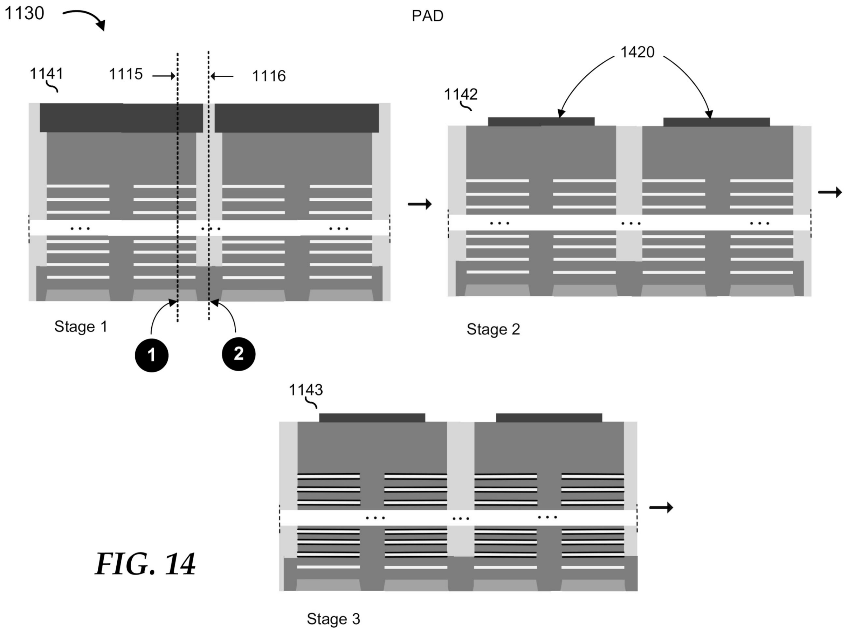

FIG. 14 is a diagram illustrating the first part 1131 of the masking process flow 1130 shown in FIG. 11 of fabrication of the monolithic WL in a pad view according to an embodiment. The first part 1131 includes structures 1141, 1142, and 1143 corresponding to stages 1, 2, and 3 shown in FIG. 11, respectively.

Stage 1 forms the structure 1141 with the mask 1140. The virtual lines, or reference lines, 1 and 2 are the same as the respective lines the structure 1121 in FIG. 12. Stage 2 forms the structure 1142. The mask 1410 in the structure 1141 becomes mask 1420. Stage 3 forms the structure 1143,

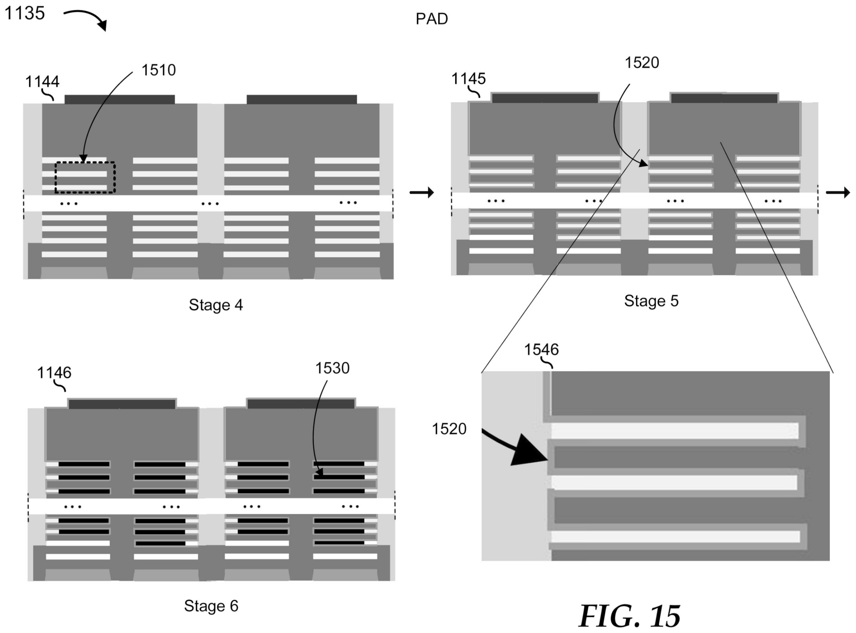

FIG. 15 is a diagram illustrating the second part 1132 of the masking process flow 1130 shown in FIG. 11 of fabrication of the monolithic WL in an array view according to an embodiment. The second part 1132 includes structures 1144, 1145, and 1146 corresponding to stages 4, 5, and 6 shown in FIG. 11, respectively.

Stage 4 forms the structure 1144 by cleaning the liner oxide, resulting cleaned semiconductor and dielectric channels 1510. Stage 5 forms the structure 1145 by depositing gate oxide 1520 at the semiconductor and dielectric channels. An expanded view 1540 shows the gate oxide 1520. This stage is similar to the first part of stage 7 in the capping process shown in FIG. 3. Stage 6 forms the structure 1146 by depositing metal (e.g., Ti, W) into the hollow spaces in the array area and pad area to form a WL 1530. This stage is similar to the second part of stage 7 in the capping process shown in FIG. 3.

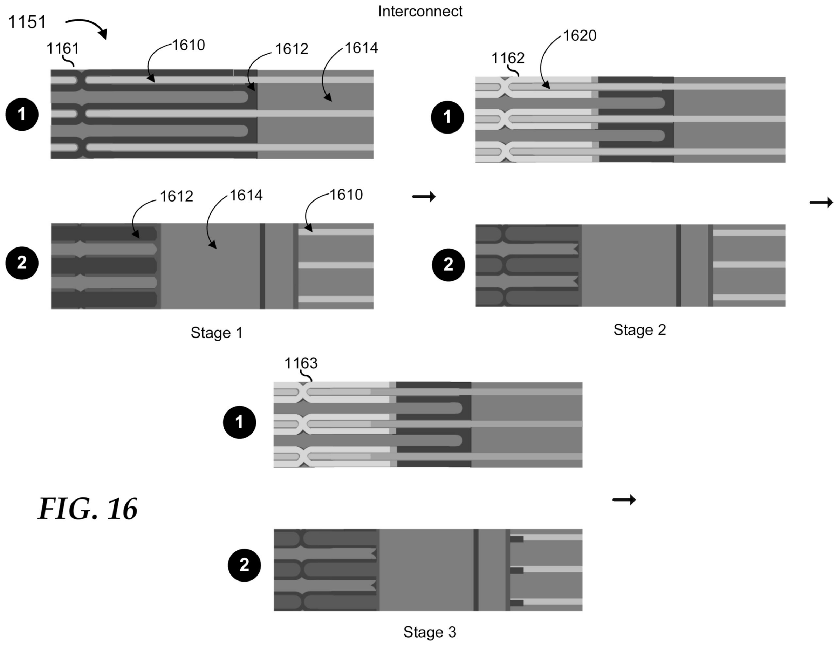

FIG. 16 is a diagram illustrating the first part 1151 of the masking process flow 1130 shown in FIG. 11 of fabrication of the monolithic WL in an interconnecting view according to an embodiment. The first part 1151 includes structures 1161, 1162, and 1163 corresponding to stages 1, 2, and 3 shown in FIG. 11, respectively.

Stage 1 forms the structure 1161 with the virtual lines 1 and 2 shown in the structure 1121 in FIG. 12 and the structure 1141 in FIG. 14. The structure 1161 has semiconductor 1610 and dielectrics 1612 and 1614. Stage 2 forms the structure 1162 having liner recess 1620. Stage 3 forms the structure 1163.

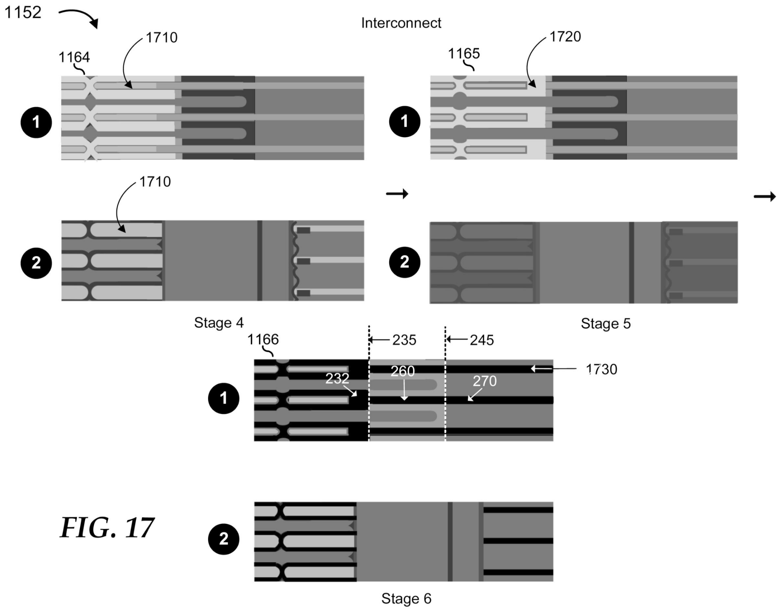

FIG. 17 is a diagram illustrating the second part 1152 of the masking process flow 1130 shown in FIG. 11 of fabrication of the monolithic WL in an interconnecting view according to an embodiment. The second part 1152 includes structures 1164, 1165, and 1166 corresponding to stages 4, 5, and 6 shown in FIG. 11, respectively.

Stage 4 forms the structure 1164 having cleaned liner oxide 1710. Stage 5 forms the structure 1165 by depositing gate oxide 1720 at the semiconductor and dielectric channels. This stage is similar to the first part of stage 7 in the capping process shown in FIG. 3. Stage 6 forms the structure 1166 by depositing metal (e.g., Ti, W) into the hollow spaces in the array area and pad area to form conductive pathway 1730. This stage is similar to the second part of stage 7 in the capping process shown in FIG. 3. The conductive pathway 1530 includes the array WL 232, interconnecting WL 260, and pad WL 270 shown in FIG. 2. The structure 1166 also includes the first and second edges 235 and 245 shown in FIG. 2

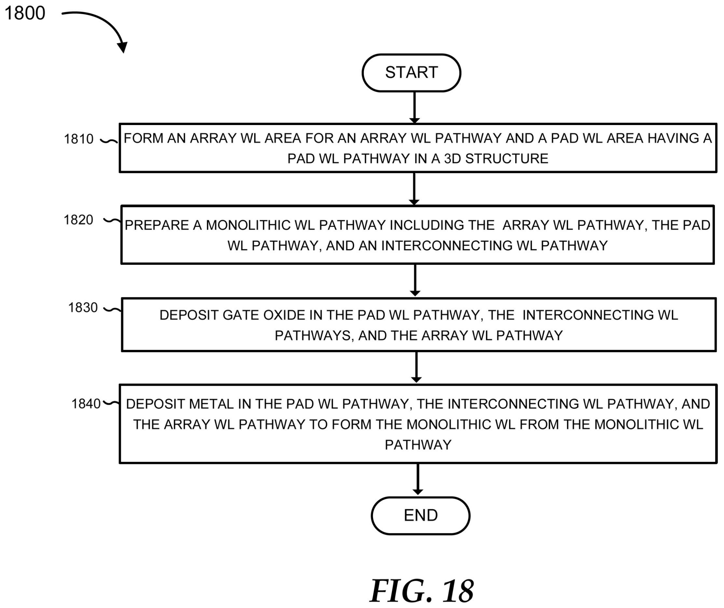

FIG. 18 is a flow chart illustrating a process 1800 of fabricating the monolithic WL structure for a memory circuit according to an embodiment. The process 1800 corresponds to the capping and masking embodiments shown in FIG. 3 and FIG. 11. For brevity, not all the correspondences between the structures in FIG. 3 and FIG. 11 and the processes in FIG. 18 are described.

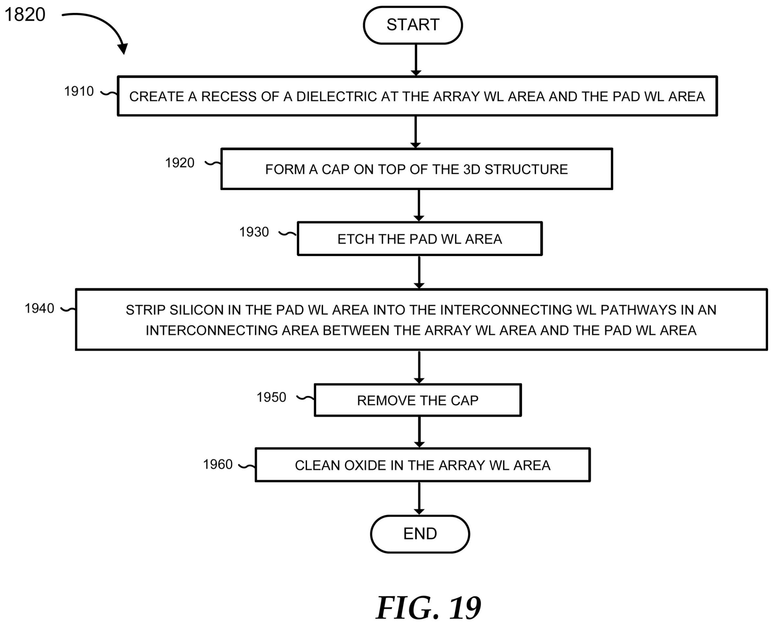

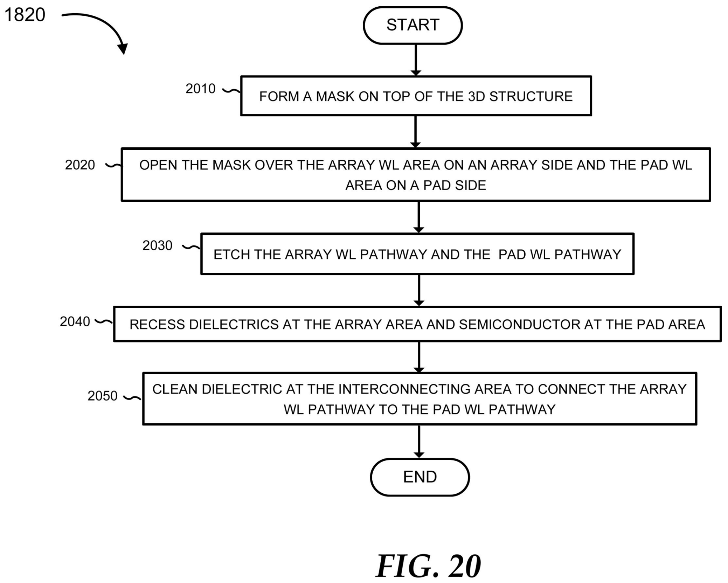

The process 1800 forms an array wordline (WL) area for one or more array WL pathways and a pad WL area having one or more pad WL pathways in a three-dimensional (3D) structure (Process 1810). Next, the process 1800 prepares one or more monolithic WL pathways comprising the one or more array WL pathways, the one or more pad WL pathway, and one or more interconnecting WL pathways (Process 1820). The process 1820 implements the capping process described in FIG. 19 and the masking process described in FIG. 20.

Then, the process 1800 deposits gate oxide in the one or more pad WL pathways, the one or more interconnecting WL pathways, and the one or more array WL pathways (Process 1830). Next, the process 1800 deposits metal in the one or more pad WL pathways, the one or more interconnecting WL pathways, and the one or more array WL pathways to form one or more monolithic WLs from the one or more monolithic WL pathways at the same time (Process 1840). The metal may be at least one of tungsten (W), titanium nitride (TiN), molybdenum (Mo), aluminum (Al), copper (Cu), Cobalt (Co). ruthenium (Ru), iridium (Ir), platinum (Pt), tantalum (Ta), or rhodium (Rh), or any combination of these materials. The process 1800 next performs various cleaning up tasks and is then terminated. The process 1840 results in the structures 327 in FIG. 5, 347 in FIG. 7, and 367 in FIG. 9 (for the capping embodiment) and 1126 in FIG. 13, 1146 in FIG. 15, and 1166 in FIG. 7 (for the masking embodiment).

FIG. 19 is a flow chart illustrating the process 1820 of preparing one or more monolithic WL pathways shown in FIG. 18 using capping according to an embodiment. The process 1820 represents parts of the stages 1 through 7 shown in FIG. 3 for three views 3D 310, array 330, and pad 350.

The process 1820 creates a recess of a dielectric at the array WL area and the pad WL area (Process 1910). The process 1910 results in the structures 321 in FIG. 4, 341 in FIG. 6, and 361 in FIG. 8. Next, the process 1820 forms a cap on top of the 3D structure (Process 1920). The process 1920 results in the structures 322 in FIG. 4, 342 in FIG. 6, and 362 in FIG. 8. Then, the process 1820 etches the pad WL area (Process 1930). Next, the process 1820 strips silicon in the pad WL area into the one or more interconnecting WL pathways in an interconnecting area between the array WL area and the pad WL area (Process 1940). Then, the process 1820 removes the cap (process 1950). This may be done by ashing the cap using oxygen plasma. If the amorphous carbon is used to form the cap, ashing the cap involves using a low-temperature process with an energized gas, or plasma, to remove amorphous carbon. The process 1950 results in the structures 325 in FIG. 5, 345 in FIG. 7, and 365 in FIG. 9. Next, the process 1820 cleans oxide in the array WL area (Process 1960) and is then terminated.

FIG. 20 is a flow chart illustrating the process 1820 of preparing one or more monolithic WL pathways shown in FIG. 18 using masking according to an embodiment. The process 1820 represents parts of the stages 1 through 6 shown in FIG. 11 for three views: the array view 1110, the pad view 1130, and the interconnect view 1150.

The process 1820 forms a mask on top of the 3D structure (process 2010). The process 2010 results in the structure 1121 in FIG. 12, 1141 in FIG. 14, and 1161 in FIG. 16. Next, the process 1820 opens the mask over the array WL area on an array side and the pad WL area on a pad side (Process 2020). Then, the process 1820 etches the one or more array WL pathways and the one or more pad WL pathways (Process 2030). Next, the process 1820 etches the one or more array WL pathways and the one or more pad WL pathways with different depths by adjustment of mask thickness on the pad side (Process 2040). Next, the process 1820 recesses dielectrics at the array area and semiconductor at the pad area. cleaning dielectric at the interconnecting area to connect the one or more array WL pathways to the one or more pad WL pathways (Process 2050). The process 1820 is then terminated.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable sub-combination. Moreover, although features may be described above as acting in certain combinations and even initially claimed as such, one or more features from a claimed combination may in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a conductive element connecting an array wordline, WL, in an array area at a first edge to a pad WL in a pad area at a second edge, the conductive element being disposed in an interconnecting area between the first edge and the second edge; and
a first dielectric disposed on the array WL, the conductive element, and the pad WL, the first dielectric having a dielectric surface extending from the interconnecting area to the pad area,
wherein the conductive element and the first dielectric form a monolithic WL from the array WL and the pad WL through the second edge.

2. The device of claim 1, further comprising:
a second dielectric disposed on the first dielectric in the interconnecting area.

3. The device of claim 2, further comprising:
a third dielectric disposed on the first dielectric in the pad area.

4. The device of any one of claims 1 to 3, wherein the dielectric surface is flat and has a thickness equal to or less than a gate oxide thickness.

5. The device of claim 3, wherein the first dielectric is different from at least one of the second dielectric or the third dielectric.

6. The device of any one of claims 1 to 5, wherein the second edge is a unit block edge.

7. The device of any one of claims 1 to 6, wherein the conductive element comprises a metal.

8. The device of claim 7, wherein the metal comprises at least one of tungsten, W, titanium nitride, TiN, molybdenum, Mo, aluminum, Al, copper, Cu, Cobalt, Co. ruthenium, Ru, iridium, Ir, platinum, Pt, tantalum, Ta, or rhodium, Rh.

9. The device of any one of claims 1 to 8, wherein the array WL is shorter than the pad WL.

10. The device of any one of claims 1 to 9, wherein the array WL and the pad WL are WLs of a three-dimensional, 3D, memory circuit.

11. A method comprising:
forming an array wordline, WL, area for an array WL pathway and a pad WL area having a pad WL pathway in a three-dimensional, 3D, structure;
preparing a monolithic WL pathway comprising the array WL pathway, the pad WL pathway, and an interconnecting WL pathway;
depositing gate oxide in the pad WL pathway, the interconnecting WL pathway, and the array WL pathway; and
depositing metal in the pad WL pathway, the interconnecting WL pathway, and the array WL pathway to form a monolithic WL from the monolithic WL pathway.

12. The method of claim 11, wherein preparing the monolithic WL pathway comprises:
creating a recess of a dielectric at the array WL area and the pad WL area;
forming a cap on top of the 3D structure;
etching the pad WL area; and
stripping silicon in the pad WL area into the interconnecting WL pathway in an interconnecting area between the array WL area and the pad WL area.

13. The method of claim 12, wherein preparing the monolithic WL pathway further comprises:
removing the cap; and
cleaning oxide in the array WL area.

14. The method of any one of claims 11 to 13, wherein preparing the monolithic WL pathway comprises:
forming a mask on top of the 3D structure;
opening the mask over the array WL area on an array side and the pad WL area on a pad side;
etching the array WL pathway and the pad WL pathway;
recessing dielectrics at the array area and semiconductor at the pad area; and
cleaning dielectric at the interconnecting area to connect the array WL pathway to the pad WL pathway.

15. The method of claim 14, wherein etching the array WL pathway and the pad WL pathway comprises:
etching the array WL pathway and the pad WL pathway with different depths by adjustment of mask thickness on the pad side.
